# EUROPEAN PATENT APPLICATION

(11) **EP 2 463 794 A1**
(43) Date of publication of application: **13.06.2012**
(21) Application number: 12155180.8
(22) Date of filing: 13.02.2012
(51) Int. Cl.: G06F 17/50

(54) **Methods and systems for optimized wind turbine park configuration**

(30) Priority: 11.02.2011 NO 20110235
(71) Applicant: Modi Vivendi AS, 0258 Oslo (NO)
(72) Inventor: The designation of the inventor has not yet been filed
(74) Representative: Gardiner, Stephen Robin

(57) **Abstract**

A method of producing a design for a set of foundation structures, the set of foundation structures comprising a plurality of individual foundation structures, the method comprising: specifying one or more design criteria for the set of foundation structures; generating a plurality of designs for the set of foundation structures, each design meeting said design criteria and each design comprising an arrangement for each individual foundation; calculating a cost for each of said plurality of designs; and selecting one of said plurality of designs based on at least said calculated cost. Alternatively, the method calculates an energy output of energy producing means installed on top of or within the structures of each of said plurality of designs and selects one of said plurality of designs based on at least said calculated energy output. By analysing several potential designs, the cost and/or energy output can be optimized subject to the design constraints, thus rapidly arriving at an optimized design for the set of structures.

## Description

This invention relates to methods and systems for designing a set of foundation structures, in particular for optimized wind turbine park configuration. Preferred embodiments relate to the construction and/or installation of wind turbine foundations of a modular design. The invention is particularly applicable in offshore applications, but can also be applied to onshore applications.

A wind turbine tower structure is the slender erected vertical body which carries the rotor, hub, turbine, generator, nacelle and tower, among other essential components, and represents a total system usually provided by a wind turbine manufacturer.

Based on various water depths and seabed conditions, several approaches have been utilized in the construction and application of foundations for offshore wind turbine tower structures. A wind turbine foundation system is a support structure comprising all components making up the system between the base of the wind turbine tower structure, most likely located approximately 15 m above normal sea level, and including the anchoring and/or the grounding mechanisms to the seabed, providing stability and integrity to the total system (tower and foundation).

Many of the utilized and proposed foundation concepts for offshore wind turbine structures, utilize designs borrowed from the oil and gas industry. For onshore or very shallow waters (< 30 m of water depth), gravity based foundations are often applied. Gravity foundations consist of a large base, constructed from either concrete or steel, which rests on the seabed. A variation of this concept is the suction bucket or "smart gravity base". These approaches are currently used on most offshore wind projects.

Down to about the same water depths as gravity base structures are used, but at different seabed conditions, mono pile foundations can be applied. The mono pile consists of a steel pile which is driven approximately 10 - 20 m into the seabed.

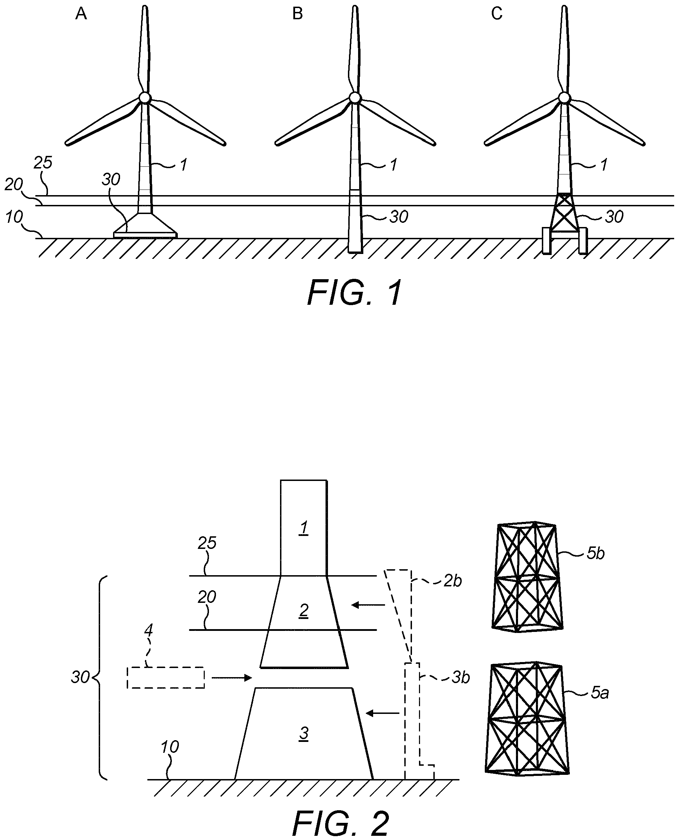

For water depths greater than 30 m, down to approximately 50 m, tripod foundations can be used. The concept utilizes several support piles which are driven, typically 10 m - 20 m into the seabed. The approach can be combined with a gravity based center structure. A variation of the tripod is the jacket foundation, similar to a lattice tower, applied in shallow and/or semi-deepwater oil operations. Figure 1 illustrates these different foundation types.

Other proposed foundation concepts are the Mobile Self-Installing Platform (MSIP), a three legged platform able to be towed out to sea and lowered into place, and the Sway concept, representing a floating spar buoy that is about 200 m tall, anchored to the seabed and designed to rise and fall with wave activity.

Among floating foundation prototypes, are the ballast stabilized (and moored), mooring line stabilized and the buoyancy stabilized (and moored) concepts.

The methods and systems claimed in this document apply to all the above mentioned concepts for foundation and/or anchoring, but are not limited to such implementations.

In this document, a park (or farm, group or plant which are all used in this document as synonyms for park) of offshore or onshore wind turbine tower (and foundation) structures (units) means at least two such units which are interconnected, e.g. by wireless means or cables and/or which are operated from a common command and control facility or which are located in a defined geographical area. A group of wind tower and foundation structures can constitute up to several thousand units. The total costs of recent (2010) offshore wind turbine projects are in the range of NOK 25 - 30 million per MW of installed turbine power output or typically NOK 75 - 110 million per integrated wind turbine offshore tower structure, including all electrical installations and foundation system(s). Total foundation costs may represent 30% - 40% of the total costs.

Water depths, seafloor and surface land topography may vary. Shading and wake interference between individual or groups of wind turbine units can also be present. All these aspects provide a need for variable foundations and for the optimization of hub heights or elevations for individual wind tower structures within a farm.

There is therefore a need for algorithms emphasizing cost minimization and output (energy) maximization. In particular there is a need for algorithms for the minimization of foundation costs subject to optimal hub elevations (for maximum energy output), by optimizing the foundation height of individual wind turbine structures.

Some prior art can be highlighted as follows:
US 2010/0135728 (Nadarajah et al) relates to mobile offshore oil drilling and production platforms, and the installation and de-installation of such.

CA 2684496 (Heskin & Andress) relates to offshore platform substructures comprising a concrete body with central opening and guidepost holes(s) extending through a height of the concrete body, wherein a width of the concrete body is greater than the height.

NO 921561 (Gudmestad et al) outlines a re-usable platform or a jackable platform which is made up of modules, designed to be stacked onto each other. The modules may have a hollow design with open bottom, which are to be filled with a filling material.

WO 2008/092462 (Pedersen) relates to a group of wind power plants for positioning in approximately the same wind climate.

EP 2246563 (Gundling) discloses a method for configuration of wind turbines by modelling the wind state with wake effects at the respective wind turbine locations. The selection of turbine configuration includes selection of a turbine hub height that minimizes wake loss of the individual wind turbines as a function of the actual wind conditions predicted for the turbine location.

Wind turbine park layouts can be generated using commercially available modelling software such as WindPro ™, WindFarmer ™ or WindFarm™. To minimize costs or maximize financial metrics, the same software manufacturers offer analysis modules to manually adjust the park layout.

WO 2008/092462 describes a method for designing a wind turbine plant wherein at least one group of wind turbines within the farm are selected to produce a non-optimal output as compared to another group of wind turbines for the same wind conditions, in order to achieve a more even output for the entire plant. The commercially available wind park programs, and the teaching of WO 2008/092462 have the disadvantage, among others, that they view the wind plant as a single power producing unit subjected to an overall site condition, rather than a cluster of individual turbines subjected to unique wind conditions.

EP 2246563 does not mention the use of variable foundations, only implying using the terrain to obtain optimal hub heights.

Objects of at least the preferred embodiments of the invention are cost minimization and output (energy) maximization, with particular emphasis on minimization of foundation costs for a park of (individual) wind turbine tower structures, subject to optimal hub elevations (for maximum energy output) and locations.

To lower costs in providing foundations to wind turbine tower structures, and/or maximize energy output by optimizing the height above normal sea level or the ground or geographical location of each individual turbine tower structure (hub elevation) within a park, the utilization of standardized vertical and/or horizontal building blocks or modules can be applied. This includes all phases from design, construction, transportation, assembly and installation of foundations for wind turbine tower structures, rather than to customize each foundation.

In other words, rather than custom building each foundation in the park, each foundation can have a customized design (size, shape, height, etc.), but is built using a number of standardized blocks.

According to a first aspect, the invention provides a method of producing a design for a set of foundation structures, the set of foundation structures comprising a plurality of individual foundation structures, the method comprising: specifying one or more design criteria for the set of foundation structures; generating a plurality of designs for the set of foundation structures, each design meeting said design criteria and each design comprising an arrangement for each individual foundation; calculating a cost for each of said plurality of designs; and selecting one of said plurality of designs based on at least said calculated cost.

Energy producing means in this context include the hub, rotor, turbine, generator, nacelle, tower, cables or any other components necessary to make a wind turbine operational in producing electric energy.

In preferred embodiments the design is modular and the step of generating a design includes selecting modules from a group comprising predefined modules.

The modules may include substantially horizontal and/or substantially vertical modules and/or the modules may have zero or negative dimensions. Negative dimensions of a module in this context will represent the removal of well defined volume(s) of mass from the seabed or on-land. In some embodiments, the concept of a negative module may also be applied to the shortening of a wind turbine tower structure and/or the installation of variable models of wind turbine tower structures, with variable dimensions (heights).

In a most preferred embodiment, iterative calculations are made to minimize total costs and maximize total energy output associated with design, manufacturing, transportation, assembly, installation and/or the operation of a park by applying an optimal number of predefined standard foundation modules.

Analytically, foundations and/or modules can be substantial (positive dimensions), or they may have zero or negative dimensions (for example, negative dimensions may indicate mass removal or shortening of structures, a zero dimension may represent an original dimension which does not change).

Preferably the cost is calculated based on one or more of manufacturing cost, transportation cost and installation cost of all modules required by the design.

In preferred embodiments the method comprises iteratively generating a design for the set of foundation structures, calculating the cost for said design and modifying said design so as to reduce the cost.

The step of generating a design may include minimizing the number of different modules required by the design.

The step of generating a design may include maximizing the number of occurrences in the design of at least one module.

Preferably the design criteria include one or more of: geographical locations of foundations, heights of foundations, widths of foundations, depths of foundations, areas of foundations, required elevations of foundations, removal of foundations, shapes and/or geometries of foundations.

The foundation structures may be on-land wind turbine foundation structures. Alternatively, the foundation structures may be offshore wind turbine foundation structures or they may be structures for on-land/offshore oil & gas operations.

The step of generating a design may include designing custom modules. It will be appreciated that a design may be represented by one single module and that such single module may be a custom module.

Custom in this context includes (but is not limited to) the design, manufacturing and installation of a module, sub module, system of modules and/or foundation structure(s) specifically for the geographical location in question.

According to another aspect, the invention provides a system for producing a design for a set of foundation structures, the set of foundation structures comprising a plurality of individual foundation structures, the system comprising one or more processors arranged to: receive one or more design criteria for the set of foundation structures; generate a plurality of designs for the set of foundation structures, each design meeting said design criteria and each design comprising an arrangement for each individual foundation; calculate a cost for each of said plurality of designs; and select one of said plurality of designs based on at least said calculated cost.

The invention also extends to a set of foundation structures, wherein at least two individual foundation structures within the set comprise a plurality of modules and wherein at least one of said at least two individual foundation structures comprises at least one module which has identical geometry to another module of said at least two individual foundation structures. Preferably the overall structure of said two individual foundation structures is different, i.e. they are not identical structures. Preferably a module of identical geometry is used in each of said two individual foundation structures. The reuse of modules (either within an individual structure or in multiple individual structures) simplifies and reduces the cost of manufacturing, while still allowing the overall structures to be configured individually.

According to another aspect, the invention provides a software product comprising instructions which when executed by a computer cause the computer to produce a design for a set of foundation structures, the set of foundation structures comprising a plurality of individual foundation structures, by carrying out the steps of: identifying one or more design criteria for the set of foundation structures; generating a plurality of designs for the set of foundation structures, each design meeting said design criteria and each design comprising an arrangement for each individual foundation; calculating a cost for each of said plurality of designs; and selecting one of said plurality of designs based on at least said calculated cost.

The software product may be a physical data carrier. The software product may comprise signals transmitted from a remote location.

According to a further aspect, the invention provides a method of producing a design for a set of foundation structures, the set of foundation structures comprising a plurality of individual foundation structures, the method comprising: specifying one or more design criteria for the set of foundation structures; generating a plurality of designs for the set of foundation structures, each design meeting said design criteria and each design comprising an arrangement for each individual foundation; calculating an energy output of energy producing means installed on top of or within the structures of each of said plurality of designs; and selecting one of said plurality of designs based on at least said calculated energy output.

According to this aspect, the main goal of the design optimization is the energy output. The cost of the design may be one of the design criteria and thus used as an optimization constraint.

According to another aspect, the invention provides a system for producing a design for a set of foundation structures, the set of foundation structures comprising a plurality of individual foundation structures, the system comprising one or more processors arranged to: receive one or more design criteria for the set of foundation structures; generate a plurality of designs for the set of foundation structures, each design meeting said design criteria and each design comprising an arrangement for each individual foundation; calculate an energy output of energy producing means installed on top of or within the structures of each of said plurality of designs; and select one of said plurality of designs based on at least said calculated energy output.

According to another aspect, the invention provides a software product comprising instructions which when executed by a computer cause the computer to produce a design for a set of foundation structures, the set of foundation structures comprising a plurality of individual foundation structures, by carrying out the steps of: identifying one or more design criteria for the set of foundation structures; generating a plurality of designs for the set of foundation structures, each design meeting said design criteria and each design comprising an arrangement for each individual foundation, among; calculating an energy output of energy producing means installed on top of or within the structures of each of said plurality of designs; and selecting one of said plurality of designs based on at least said calculated energy output.

Each of the preferred features described above in relation to the method are equally applicable to the system, end product and software.

In this document, a module may be defined as a component (often interchangeable) of a system or construction that is designed for easy assembly or flexible use.

In the context of wind turbine foundations, modules may be any vertical and/or horizontal subset or standardized unit, component or structural element, preferably, but not limited to, being applied as building blocks to all units within a park of tower structures. The modules may be substantially vertical or substantially horizontal, these terms referring to the orientation in which they are intended to be used.

Modules may be designed, constructed and transported independently. They may be designed for easy assembly by combinations of welding, bolts, nuts, glue, nails, friction, heat, cold, shrink and/or expansion techniques, magnetized and/or electric connections.

Modules can have a variety of physical and geometric shapes or characteristics, among, but not limited to; jackets, cubes, cylinders, frames, half frames, two pods, three pods, four pods, cones, pyramids, spheres, and/or parts of such geometries and combinations thereof. Modules may have variable densities, different types of materials and/or different material properties. Combinations of these may apply within the same module and from one module to another. In some embodiments a module may also represent the removal of mass from the seabed or on land or the shortening of a structure. Such modules may be represented by using zero or negative dimensions.

In one embodiment, based on input and/or calculations among, but not limited to: water depths, seabed conditions, on-land/offshore topography, height (from base to hub), wind conditions, temperature, humidity, sea state(s), currents, salinity, weight distribution, material specifications of the wind turbine tower structure, forces, moments, stress, strain, corrosion, coating, specific governmental rules and regulations, regulatory and/or classification body requirements; certain (preliminary) design criteria for the entire geographical location of the park and/or for individual foundations within a park of offshore wind turbine structures or group of such structures, are stated.

It has to be emphasized that iterative procedures, e.g. utilizing available modelling software, may be applied to obtain optimal individual hub and foundation heights (and locations). Design criteria could also include types of building or construction material for the foundations, among combinations of concrete, one or more metals, alloys, plastics, polymers, fiber glass and composite materials with corresponding different material specifications. Further calculations, especially related to foundations, can be made by computer based software utilizing e.g. the finite element method. A module, with well defined geometric, material and/or physical dimensions, values and specifications, can represent a standard element in such computer based calculations.

Based on, but not limited to, the stated or calculated design criteria; design and/or physical dimensions are calculated for the foundation(s). Based on these calculations and/or design criteria, the foundations within a park are defined into standard modules and/or the foundations are composed of already predefined standard modules. Calculations are made to determine if a global assembly and/or composition of predefined modules can fulfil the design criteria or if customized modules have to be designed and manufactured for individual foundations. To optimize hub heights and/or actual geographical locations for tower (and foundation) structures or groups of such structures due to wake effects, software from WindFarm ™, using the Eddy Viscosity model (based on the Ainslie Model), or from WindPro ™, using the Park wake model (based on the Jensen Model), can be applied.

The above stated calculations are again optionally performed as iterative processes.
Figure 1 shows foundations involving gravity base, mono pile and tripod/jacket as grounding mechanisms;
Figure 2 illustrates a modular design structure; and
Figures 3A and 3B illustrate horizontal and vertical layouts of a wind farm.

Figure 1 shows a gravity base foundation structure (A), a monopile foundation structure (B) and a tripod/jacket foundation structure (C). The level of the seabed is indicated at 10 and the sea level at 20. A base line 25 for tower structures is typically around 15 metres above sea level 20. In each illustration, the tower structure 1 sits atop a foundation structure 30.

In Figure 2, the tower structure 1 is mounted on a horizontal module 2 (in this embodiment, a trapezium shaped module), the first element of the foundation system, measured from the base of the tower structure, which in turn sits atop a second horizontal module 3 (also a trapezium in this embodiment, of larger dimension than the first module, with the lower surface of the first module designed to substantially match the upper surface of the second module). Horizontal modules, 2, 3, can be supplemented by vertical modules 2b, 3b if design criteria require additional support and/or strength to the foundation. As shown in Figure 2, these vertical modules may be of generally triangular cross section (as illustrated by 2b) or of an L-shaped cross section (as illustrated by 3b). These elements may be formed as buttresses extending from the main structure 2, 3 or they may be formed as rings surrounding the whole of the main structure 2, 3.

Additional horizontal modules 4 can be added if varying water depths/seabed topography and/or different design criteria require so. As illustrated in Figure 2, horizontal module 4 is of generally rectangular cross section and substantially matches both upper and lower horizontal modules 2, 3, although this need not always be the case. Elements 5a and 5b are examples of a jacket type of horizontal module, designed to preferably be stacked onto each other, e.g. with element 5b stacked on top of element 5a and affixed thereto.

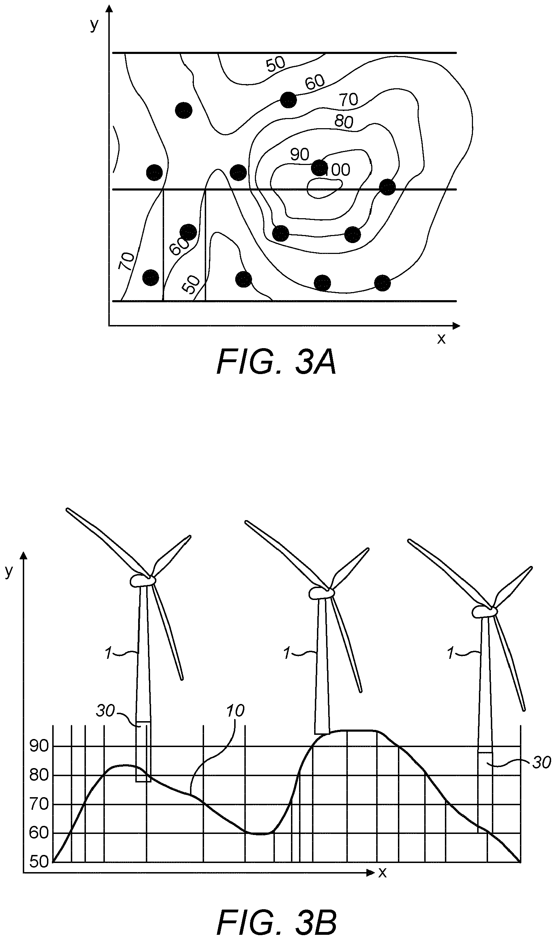

Figures 3A and 3B are respectively the horizontal (xy) and vertical (xz) layouts of an example of a farm. Preliminary horizontal (i.e. geographical locations of individual tower structures) and vertical layouts (i.e. hub heights above normal sea level 10 and/or elevations/distance above the ground), will normally have to be adjusted in iterative procedures, utilizing procedures described herein, including those provided by the stated references/prior art.

In one embodiment, such calculations are done with the goal of minimizing costs for the foundation by employing an optimal number of predefined standard modules. In a further embodiment, iterative calculations are made for all foundations constituting a park (i.e. a set of organized units) of offshore tower structures by employing an optimal number of predefined standard modules, subject to optimal hub height above normal sea level for the individual wind turbine tower (and foundation) structures with the primary goal of maximizing energy output of the entire wind turbine park and the secondary goal of minimizing costs.

In a preferred embodiment iterative calculations are made to minimize the total costs associated with design, manufacture, transportation, assembly and/or installation of a park or group of foundations by employing an optimal number of predefined standard modules. For example, the cost of manufacture and transportation will depend on the geographical locations of the factory and the farm. In some cases a large number of smaller modules will be less expensive to manufacture and transport. In other cases a smaller number of large modules may be less expensive (i.e. more optimal) to manufacture and transport.

It will be appreciated that, in the above descriptions, modules can be composed of sub-modules. Further, for the sake of analytical procedures, a module and/or sub module may have zero or negative dimensions, with negative dimensions representing the removal of matter.

The procedures described above have been described in relation to offshore wind farms, but are equally applicable to equivalent onshore/on-land situations, especially with topography with variable height distribution.

In most hookup situations the anchoring modules are preinstalled and the subsequent foundation modules are installed later in time and/or as a separate operation.

A module and/or sub modules can be manufactured at different locations and/or different moments of time at the same location.

One or several modules can be assembled and/or mounted together onshore prior to transportation offshore, to the geographical location where they are to be operational as functional foundations.

In another preferred embodiment the levels of assembly between onshore and offshore are determined by the solutions which minimize total costs for all offshore wind turbine tower and foundation structures, depending on but not limited to number of manufacturing locations for modules and/or sub modules and/or number of foundations constituting the park, subject to optimal hub height above normal sea level, for the individual wind turbine tower (and foundation) structure, to maximize energy output of the entire wind turbine park.

A modular based foundation can be assembled totally (100 %) onshore, including anchoring modules, and be shipped offshore to the location where it is to be a support structure for a tower structure.

A modular (or custom made) based foundation can typically be represented by the assembly of up to 1000 sub modules. A foundation can typically be represented by the assembly of up to 1000 modules. Beyond this limit, cost effectiveness is difficult to achieve.

In preferred embodiments, a modular based foundation is represented by the assembly of fewer than 10 modules.

One or more modules within a foundation can be custom made. In special cases all the foundations can be custom made.

The described methods and systems, can also be applied as foundations to offshore and onshore oil and gas operations (exploration and production) systems or facilities, besides to onshore wind turbine tower structures. Onshore or on-land are any land area including mash land soil conditions and/or a geographical area with topography with variable height distribution like hills and mountains.

The invention is not limited to the methods and systems described above, thus all approaches that are functionally equivalent are included by the scope of the invention. Drawings and figures are to interpreted illustratively and not in a limiting context. It is further presupposed that all the claims shall be interpreted to cover all generic and specific characteristics of the invention which are described, and that all aspects related to the invention, no matter specific use of language, shall be included. Thus, the stated references have to be interpreted to be included as part of this invention's basis, methodology, mode of operation, methods and systems. It should also be noted that the features of each of the above embodiments can be applied alone or in combination with the features of any of the other embodiments.

A most preferred embodiment includes all the various features, systems and references described above.

## Claims

1. A method of producing a design for a set of foundation structures, the set of foundation structures comprising a plurality of individual foundation structures, the method comprising:
- specifying one or more design criteria for the set of foundation structures;
- generating a plurality of designs for the set of foundation structures, each design meeting said design criteria and each design comprising an arrangement for each individual foundation;
calculating a cost for each of said plurality of designs; and
- selecting one of said plurality of designs based on at least said calculated cost.

2. A method as claimed in claim 1, wherein a design can be modular and the step of generating a design includes selecting modules from a group comprising predefined modules.

3. A method as claimed in claim 1, or 2, wherein the modules include substantially horizontal and/or substantially vertical modules, having positive, zero and/or negative dimensions.

4. A method as claimed in any preceding claim, wherein the cost is calculated based on one or more of manufacturing cost, transportation cost and installation cost of all modules required by the design.

5. A method as claimed in any preceding claim, wherein the method comprises iteratively generating a design for the set of foundation structures, calculating the cost for said design and modifying said design so as to reduce the cost.

6. A method as claimed in any preceding claim, wherein the step of generating a design includes minimizing the number of different modules required by the design.

7. A method as claimed in any preceding claim, wherein the step of generating a design includes maximizing the number of occurrences in the design of at least one module.

8. A method as claimed in any preceding claim, wherein the design criteria include one or more of geographical locations of foundations, heights of foundations, widths of foundations, depths of foundations, areas of foundations, required elevations of foundations, removal of foundations, shapes and/or geometries of foundations.

9. A method as claimed in any preceding claim, wherein the step of generating a design includes designing custom modules and/or a design can be represented by one single module and that such single module can be custom.

10. A system for producing a design for a set of foundation structures, the set of foundation structures comprising a plurality of individual foundation structures, the system comprising one or more processors arranged to:
- receive one or more design criteria for the set of foundation structures;
- generate a plurality of designs for the set of foundation structures, each design meeting said design criteria and each design comprising an arrangement for each individual foundation;
- calculate a cost for each of said plurality of designs; and
- select one of said plurality of designs based on at least said calculated cost.

11. A set of foundation structures, wherein at least two individual foundation structures within the set comprise a plurality of modules and wherein at least one of said at least two individual foundation structures comprises at least one module which has identical geometry to another module of said at least two individual foundation structures.

12. A software product comprising instructions which when executed by a computer cause the computer to produce a design for a set of foundation structures, the set of foundation structures comprising a plurality of individual foundation structures, by carrying out the steps of:
- identifying one or more design criteria for the set of foundation structures;
- generating a plurality of designs for the set of foundation structures, each design meeting said design criteria and each design comprising an arrangement for each individual foundation;
- calculating a cost for each of said plurality of designs; and
- selecting one of said plurality of designs based on at least said calculated cost.

13. A software product as claimed in claim 12, wherein the software product is a physical data carrier.

14. A software product as claimed in claim 12, wherein the software product comprises signals transmitted from a remote location.

15. A method of producing a design for a set of foundation structures, the set of foundation structures comprising a plurality of individual foundation structures, the method comprising:
- specifying one or more design criteria for the set of foundation structures; generating a plurality of designs for the set of foundation structures, each design meeting said design criteria and each design comprising an arrangement for each individual foundation;
- calculating an energy output of energy producing means installed on top of or within the structures of each of said plurality of designs; and
- selecting one of said plurality of designs based on at least said calculated energy output.
